# EUROPÄISCHE PATENTSCHRIFT

(11) **EP 3 001 167 B1**
(45) Veröffentlichungstag und Bekanntmachung des Hinweises auf die Patenterteilung: **11.10.2017**
(21) Anmeldenummer: 15179661.2
(22) Anmeldetag: 04.08.2015
(51) Int. Cl.: G01L 9/00, G01L 23/10, G01L 1/16, H01L 41/113

(54) **SENSORANORDNUNG UND VERFAHREN ZUR HERSTELLUNG EINER SENSORANORDNUNG**
SENSOR ASSEMBLY AND METHOD FOR PRODUCING A SENSOR ASSEMBLY
SYSTEME DE CAPTEUR ET PROCEDE DE FABRICATION D'UN SYSTEME DE CAPTEUR

(30) Priorität: 26.09.2014 DE 102014219532
(43) Veröffentlichungstag der Anmeldung: 30.03.2016
(73) Patentinhaber: ROBERT BOSCH GMBH, 70442 Stuttgart (DE)
(72) Erfinder: Kreschel, Henning, 71640 Ludwigsburg (DE); Haug, Stefan, 71111 Waldenbuch (DE); Forke, Martin, 70499 Stuttgart (DE); Schnaufer, Axel, 70435 Stuttgart (DE); Stieber, Marco, 71665 Vaihingen An Der Enz (DE); Fischer, Fabian, 70176 Stuttgart (DE)

(56) Entgegenhaltungen:
- EP-A1- 2 832 707
- DE-A1-102011 078 905
- US-B1- 6 523 423

## Beschreibung

Die Erfindung betrifft eine Sensoranordnung zur Kraft- und/oder Druckmessung, insbesondere für den Anbau an einem Kraftstoffinjektor zur Ventilnadelschließzeitpunkterkennung, umfassend wenigstens ein Sensorelement aus einem piezoelektrischen Werkstoff mit zwei parallel zueinander liegenden gegenüberliegenden Stirnflächen mit jeweils einer zugeordneten Elektrode, wobei eine Kontaktierung mit den voneinander elektrisch getrennten Elektroden vorgesehen ist. Weiterhin betrifft die Erfindung ein Verfahren zur Herstellung einer solchen Sensoranordnung.

### Stand der Technik

Eine solche Sensoranordnung ist aus der DE 10 2011 078 905 A1 bekannt. Diese Sensoranordnung weist zwei Sensorelemente aus jeweils einem piezoelektrischen Werkstoff auf, wobei die beiden Sensorelemente jeweils auf ihren Stirnflächen mit einer Elektrode versehen sind. Um eine elektrische Kontaktierung mit den aufeinanderliegenden Elektroden der beiden Sensorelemente herzustellen ist eine Mittelelektrode vorgesehen, die mit einem Kontaktierungsdraht verbunden ist, der im Bereich der aufeinanderliegenden Stirnflächen der Elektroden nach außen geführt ist. Alternativ zu dem Kontaktierungsdraht ist die Mittelelektrode nach außen geführt und stellt somit eine elektrische Anschlussmöglichkeit dar. Die beiden gegenüberliegenden Elektroden auf den voneinander abgewandten Stirnflächen müssen in geeigneter Weise wie die Mittelelektrode kontaktiert werden, um ein von den Sensorelementen erzeugtes Signal abführen zu können.

Die Schriften US 6 523 423 B1 und EP 2 832 707 A1 beschreiben ebenso eine Sensoranordnung zur Kraft- oder Druckmessung.

Es ist weiterhin für eine einseitige Kontaktierung der Sensoranordnung bekannt, eine der beiden Elektroden über die Mantelfläche auf die gegenüberliegende Stirnfläche der Sensoranordnung zu führen und diese in einer sichelförmigen Ausnehmung der gegenüberliegenden Elektrode zu platzieren. Diese Ausbildung verkleinert die effektive Fläche zur Signalerzeugung signifikant.

Der Erfindung liegt die Aufgabe zu Grunde, eine Sensoranordnung anzugeben, die hinsichtlich der effektiven Fläche zur Signalerzeugung verbessert ist. Weiterhin soll ein Verfahren zur Herstellung einer solchen Sensoranordung angegeben werden.

### Offenbarung der Erfindung

Diese Aufgabe wird durch die Sensoranordnung nach Anspruch 1 und das Herstellungsverfahren nach Anspruch 6 gelöst, dadurch, dass jede der beiden Stirnflächen zwei voneinander getrennte Elektrodenabschnitte aufweist, die kreuzweise bezogen auf die gegenüberliegenden Stirnfläche angeordnet und miteinander elektrisch verbunden sind. Außerdem erfolgt die kreuzweise Verbindung der ersten Elektrodenabschnitte und der zweiten Elektrodenabschnitte über jeweils einen Mantelflächenabschnitt des Elektrodenmaterials an dem Sensorelement. Die so gebildete kreuzweise Verbindung ist einfach herzustellen und zudem sehr zuverlässig. Um eine Trennung des Mantelflächenabschnitts von dem nicht zu kontaktierenden Elektrodenabschnitt zu gewährleisten, ist auf beiden Stirnflächen jeweils eine Außenumfangstrennung vorgesehen. Die Außenumfangstrennungen sind vorzugsweise außerhalb des Sensorelements angeordnet, so dass hierdurch keine Veränderung der wirksamen Fläche zur Signalerkennung erfolgt.

Das entsprechende Verfahren zum Herstellen einer Sensoranordnung ist dadurch gekennzeichnet, dass das Sensorelement mit einem das Sensorelement vollständig umfassenden Elektrodenmaterial ummantelt wird und dass das Elektrodenmaterial anschließend zur Bildung von auf jeder der beiden Stirnflächen des Sensorelements angeordneten Elektrodenabschnitten getrennt wird. Ein so ausgestaltetes Sensorelement lässt sich zunächst einmal problemlos herstellen. Die Trennung erfolgt dann derart, dass die ersten Elektrodenabschnitte und zweiten Elektrodenabschnitte deckungsgleich auf den beiden Stirnflächen kreuzweise gegenüberliegen und dass die so gebildeten ersten Elektrodenabschnitte und zweiten Elektrodenabschnitte über getrennte Mantelabschnitte einer Mantelfläche des Elektrodenmaterials miteinander verbunden sind. Die kreuzweise gegenüberliegenden Elektrodenabschnitte auf den beiden Stirnflächen des Sensorelements ermöglichen einen einseitigen elektrischen Zugang zu der Sensoranordnung, wobei darüber hinaus gegenüber bekannten Lösungen die effektive Fläche zur Signalerzeugung nicht beziehungsweise vernachlässigbar gering gegenüber einem maximal möglichen Wert verringert ist. Da die Verringerung im Grunde nur durch die notwendige Trennung der beiden Elektrodenabschnitte auf jeweils einer Stirnseite gebildet ist, ist die Verringerung der effektiven Fläche zur Signalerzeugung effektiv nicht nachweisbar. Hierbei ist zu berücksichtigen, dass die Trennung nur so ausgestaltet sein muss, dass eine elektrische Trennung der beiden Elektrodenabschnitte gewährleistet ist.

In Weiterbildung der Erfindung ist die Trennung von einer Trennfuge gebildet. Diese Trennfuge kann eine sehr geringe Breite aufweisen, die nur die elektrische Trennung der beiden Elektrodenabschnitte gewährleisten muss. Eine solche elektrische Trennung ist schon durch eine Trennfuge mit einer Breite von deutlich weniger als 1 mm gegeben, wobei bei Anwendung eines geeigneten Trennverfahrens eine Breite der Trennfuge im Bereich von einigen µm möglich ist.

In weiterer Ausgestaltung der Erfindung teilt die Trennung die Stirnflächen in jeweils zwei gleich große Elektrodenabschnitte auf. Dabei sind in weiterer Ausgestaltung die kreuzweise miteinander verbundenen ersten Elektrodenabschnitte deckungsgleich mit den jeweils zweiten Elektrodenabschnitten angeordnet. Diese Ausgestaltung ermöglicht eine maximal große effektive Fläche zur Signalerzeugung.

In weiterer Ausgestaltung ist das Sensorelement mit einem das Sensorelement vollständig umfassenden Elektrodenmaterial ummantelt, und das Elektrodenmaterial ist zur Bildung von auf jeder der beiden Stirnflächen des Sensorelements angeordneten Elektrodenabschnitten getrennt. Ein so ausgestaltetes Sensorelement lässt sich wie ausgeführt problemlos herstellen.

In weiterer Ausgestaltung des Verfahrens zur Herstellung der Sensoranordnung wird die Ummantelung durch einen Tauchvorgang oder eine Dampfbeschichtung erzeugt. Auf diese Weise ist das Elektrodenmaterial zuverlässig auf das Sensorelement auftragbar.

In Weiterbildung der Erfindung wird die Trennfuge durch ein mechanisches Trennverfahren oder ein Lasertrennverfahren hergestellt. Insbesondere mit einem Lasertrennverfahren ist eine zuverlässige Herstellung der Trennfuge mit einer geringen Spaltbreite darstellbar.

Weitere vorteilhafte Ausgestaltungen der Erfindung sind der Zeichnungsbeschreibung zu entnehmen, in der ein in den Figuren dargestelltes Ausführungsbeispiel der Erfindung näher beschrieben ist.

Es zeigen:
- Figur 1: eine Draufsicht auf eine erfindungsgemäße Sensoranordnung,
- Figur 2: einen Querschnitt durch die Sensoranordnung gemäß Figur 1,
- Figur 3: eine perspektivische Draufsicht auf eine Sensoranordnung und
- Figur 4: eine perspektivische Druntersicht auf eine Sensoranordnung.

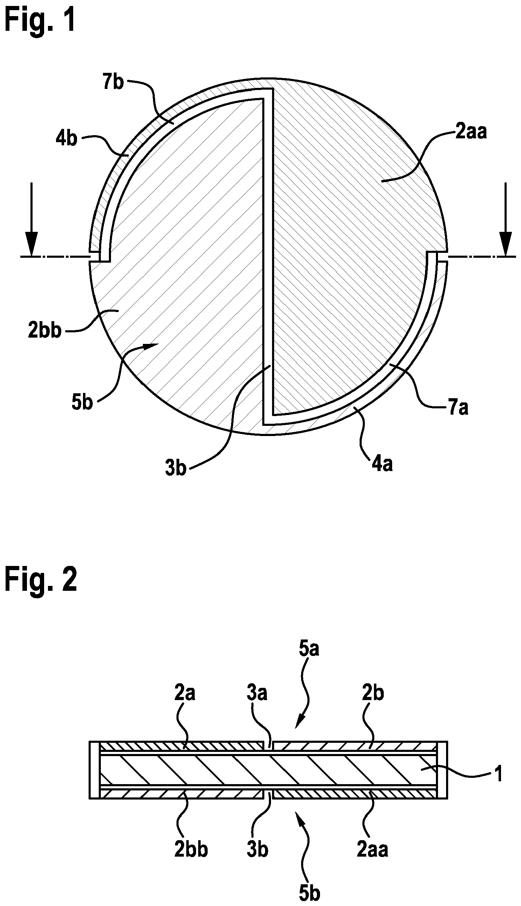

Die in Figur 1 dargestellte Sensoranordnung dient zur Erfassung einer Deformation (Dehnung oder Stauchung), welche sich durch eine Druckschwingung ändert.

In diesem Zusammenhang ist eine mögliche Anwendung die Ermittlung von Körperschallsignalen. Beispielsweise werden mit der Sensoranordnung Nadelbewegungssignale und insbesondere Nadelschließsignale von Servo-Common-Rail-Injektoren ermittelt. Dabei wird im Wesentlichen ein beim Schließen einer Düsennadel des jeweiligen Injektors ausgehendes Körperschallsignal detektiert. Dazu wird die Sensoranordnung bevorzugt mit einer ersten Stirnfläche 5a an den Injektor, beispielsweise einen Haltekörper des Injektors angeklebt oder sonst wie befestigt. Hierbei kommt auch eine Befestigung unter Aufbringung einer Vorspannung auf die Sensoranordnung in Frage, um beispielsweise einen Verschließ der Sensoranordnung durch große Deformationen zu verhindern. Um nun von der dem Injektor abgewandten und somit freien zweiten Stirnfläche 5b aus ohne einen messbaren Verlust der effektiven Fläche zur Signalerzeugung ein Signal einer Auswerteeinrichtung abführen zu können, ist die Sensoranordnung wie nachfolgend beschrieben wird, ausgestaltet.

Die Sensoranordnung weist ausweislich der Figur 2 ein Sensorelement 1 aus einem piezoelektrischen Werkstoff auf, das auf den beiden parallel zueinander liegenden gegenüberliegenden Stirnflächen 5a, 5b und der umfassenden Mantelfläche 6 von einem Elektrodenmaterial ummantelt ist. Diese Ummantelung des Sensorelements 1 mit dem Elektrodenmaterial erfolgt bevorzugt durch einen Tauchvorgang des Sensorelements 1 in ein flüssiges Elektrodenmaterial oder durch eine Dampfbeschichtung des Sensorelements 1 mit Elektrodenmaterial. Der piezoelektrische Werkstoff des Sensorelements 1 erfährt durch beispielsweise die Körperschallsignale eine Stauchung und/oder Dehnung, die ein elektrisches Signal bewirkt, das auf das Elektrodenmaterial geleitet wird und von diesem in geeigneter Weise zu der Auswerteeinrichtung weitergeleitet wird.

Um ein verwertbare Signal an dem Elektrodenmaterial zu erhalten, sind zwei Elektroden erforderlich, die durch eine Trennung des Elektrodenmaterials insbesondere auf der ersten Stirnseite 5a und der zweiten Stirnseite 5b in erste Elektrodenabschnitte 2a, 2aa und zweite Elektrodenabschnitte 2b, 2bb erzeugt werden. Diese Trennung wird durch eine Trennfuge 3a, 3b erzeugt, die jeweils mittig durch die beiden Stirnflächen 5a, 5b verläuft und die beiden Stirnflächen 5a, 5b in jeweils den ersten Elektrodenabschnitt 2a und zweiten Elektrodenabschnitt 2b auf der Stirnfläche 5a sowie den ersten Elektrodenabschnitt 2aa und zweiten Elektrodenabschnitt 2bb auf der Stirnfläche 5b aufteilt. Die Trennfugen 3a, 3b liegen genau deckungsgleich gegenüberliegend auf der ersten Stirnfläche 5a und der zweite Stirnfläche 5b und weisen eine nur zur elektrischen Trennung des Elektrodenmaterials notwendige geringe Breite vorzugsweise im µm Bereich auf.

Um die Elektrodenabschnitte 2a und 2aa sowie die Elektrodenabschnitte 2b und 2bb, kreuzweise gegenüberliegend auf den beiden Stirnflächen 5a, 5b miteinander zu verbinden, ist die Mantelfläche 6 des Elektrodenmaterials in einen Mantelflächenabschnitt 4a, und einen Mantelflächenabschnitt 4b aufgeteilt, wobei der Mantelflächenabschnitt 4a die Elektrodenabschnitte 2b und 2bb und der Mantelflächenabschnitt 4b die Elektrodenabschnitt 2a und 2aa auf den Stirnseiten 5a und 5b verbindet.

Um eine Trennung des Mantelflächenabschnitts 4a von dem Elektrodenabschnitt 2aa zu gewährleisten, ist eine Außenumfangstrennung 7a vorgesehen ebenso wie auf der genüberliegenden Stirnfläche 5a für eine Trennung des Mantelflächenabschnitts 4b von dem Elektrodenabschnitt 2bb eine Außenumfangstrennung 7b vorgesehen ist. Die Außenumfangstrennungen 7a, 7b sind vorzugsweise außerhalb des Sensorelements 1 angeordnet, so dass hierdurch keine Veränderung der wirksamen Fläche zur Signalerkennung erfolgt.

Durch diese Ausgestaltung ist eine einseitig, beispielsweise auf der ersten Stirnfläche 5a kontaktierbare Sensoranordnung geschaffen, die hinsichtlich der effektiven Fläche zur Signalerkennung maximiert ist. Die Sensoranordnung kann neben der dargestellten scheibenförmigen Ausgestaltung eine beliebige andere, beispielsweise eine rechteckige Ausgestaltung aufweisen.

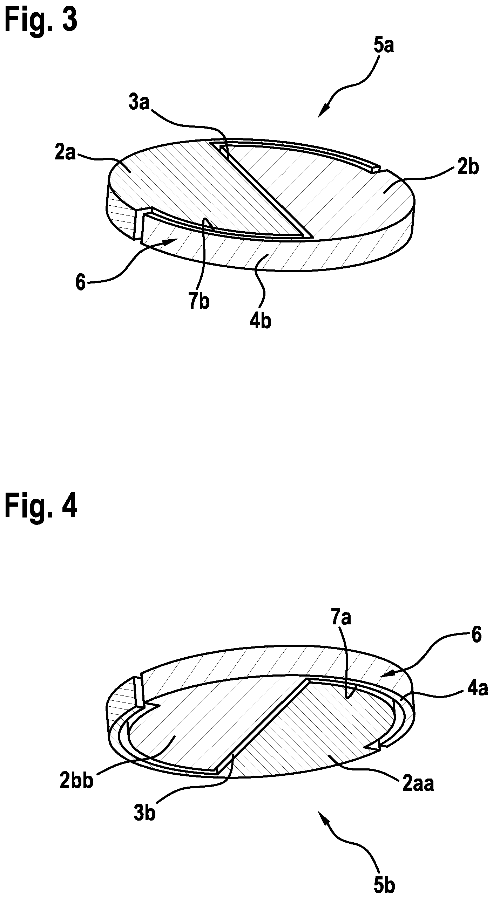

Ergänzend zu den Darstellungen der Figuren 1 und 2 geben die Figuren 3 und 4 entsprechend perspektivische Ansichten der Sensoranordnung wieder.

## Patentansprüche

1. Sensoranordnung zur Kraft- und/oder Druckmessung, insbesondere für den Anbau an einem Kraftstoffinjektor zur Ventilnadelschließzeitpunkterkennung, umfassend wenigstens ein Sensorelement (1) aus einem piezoelektrischen Werkstoff mit zwei parallel zueinander liegenden Stirnflächen (5a, 5b) mit jeweils einer zugeordneten Elektrode, wobei eine Kontaktierung des Sensorelements (1) mit den voneinander elektrisch getrennten Elektroden vorgesehen ist,
**dadurch gekennzeichnet, dass** jede der beiden Stirnflächen (5a, 5b) zwei voneinander getrennte und die Elektroden bildende Elektrodenabschnitte (2a, 2b, beziehungsweise 2aa, 2bb) aufweist, wobei die Elektrodenabschnitte (2a, 2b, beziehungsweise 2aa, 2bb) bezogen auf die gegenüberliegende Stirnfläche (5a, 5b) kreuzweise zueinander angeordnet und miteinander elektrisch verbunden sind, wobei die kreuzweise Verbindung der ersten Elektrodenabschnitte (2a, 2aa) und der zweiten Elektrodenabschnitte (2b, 2bb) über jeweils einen Mantelflächenabschnitt (4a, 4b) eines Elektrodenmaterials erfolgt.

2. Sensoranordnung nach Anspruch 1,
**dadurch gekennzeichnet, dass** die Trennung von einer Trennfuge (3a, 3b) gebildet ist.

3. Sensoranordnung nach einem der vorherigen Ansprüche,
**dadurch gekennzeichnet, dass** die Trennung die Stirnflächen (5a, 5b) in jeweils zwei gleich große Elektrodenabschnitte (2a, 2b und 2aa, 2bb) aufteilt.

4. Sensoranordnung nach einem der vorherigen Ansprüche,
**dadurch gekennzeichnet, dass** die kreuzweise miteinander verbundenen ersten Elektrodenabschnitte (2a, 2aa) deckungsgleich zu den jeweils zugeordneten zweiten Elektrodenabschnitten (2b, 2bb) angeordnet sind.

5. Sensoranordnung nach einem der vorherigen Ansprüche,
**dadurch gekennzeichnet, dass** das Sensorelement (1) mit einem Film aus Elektrodenmaterial ummantelt ist, und dass das Elektrodenmaterial zur Bildung der ersten Elektrodenabschnitte (2a, 2aa) und der zweiten Elektrodenabschnitte (2b, 2bb) getrennt ist.

6. Verfahren zum Herstellen einer Sensoranordnung zur Kraft- und/oder Druckmessung nach Anspruch 5, insbesondere für den Anbau an einen Kraftstoffinjektor zur Ventilnadelschließzeitpunkterkennung, wobei das Sensorelement (1) mit dem das Sensorelement (1) vollständig umfassenden Elektrodenmaterial ummantelt wird, dass das Elektrodenmaterial anschließend zur Bildung der von auf jeder der beiden Stirnflächen (5a, 5b) des Sensorelements (1) angeordneten und die Elektroden bildenden Elektrodenabschnitten (2a, 2aa, 2b, 2bb) so getrennt wird, dass die ersten Elektrodenabschnitte (2a, 2aa) und zweiten Elektrodenabschnitte (2b, 2bb) deckungsgleich auf den beiden Stirnflächen (5a, 5b) kreuzweise gegenüberliegen und dass die so gebildeten ersten Elektrodenabschnitte (2a, 2aa) und zweiten Elektrodenabschnitte (2b, 2bb) über die Mantelabschnitte (4a, 4b) der Mantelfläche (6) des Elektrodenmaterials jeweils miteinander verbunden sind.

7. Verfahren zur Herstellung einer Sensoranordnung nach Anspruch 6,
**dadurch gekennzeichnet, dass** die Ummantelung durch einen Tauchvorgang oder eine Dampfbeschichtung auf das Sensormaterial (1) aufgebracht wird.

8. Verfahren zur Herstellung einer Sensoranordnung nach einem der Ansprüche 6 oder 7,
**dadurch gekennzeichnet, dass** die Trennfuge (3a, 3b) durch ein mechanisches Trennverfahren oder ein Lasertrennverfahren hergestellt wird.

## Claims

1. Sensor arrangement for force and/or pressure measurement, in particular for attachment to a fuel injector for valve needle closing time identification, comprising at least one sensor element (1) which is composed of a piezoelectric material and has two end faces (5a, 5b) which are situated parallel to one another and each have an associated electrode, wherein provision is made for the electrodes which are electrically isolated from one another to make contact with the sensor element (1), **characterized in that** each of the two end faces (5a, 5b) has two mutually separate electrode sections (2a, 2b and, respectively, 2aa, 2bb) which form the electrodes, wherein the electrode sections (2a, 2b and, respectively, 2aa 2bb) are arranged crosswise in relation to one another with respect to the opposite end face (5a, 5b) and are electrically connected to one another, wherein the first electrode sections (2a, 2aa) and the second electrode sections (2b, 2bb) are connected in a crosswise manner by means of in each case one casing surface section (4a, 4b) of an electrode material.

2. Sensor arrangement according to Claim 1, **characterized in that** the separation is formed by a separating joint (3a, 3b).

3. Sensor arrangement according to either of the preceding claims, **characterized in that** the separation splits the end faces (5a, 5b) into in each case two electrode sections (2a, 2b and, respectively, 2aa, 2bb) of equal size.

4. Sensor arrangement according to one of the preceding claims, **characterized in that** the first electrode sections (2a, 2aa) which are connected to one another in a crosswise manner are arranged congruently to the respectively associated second electrode sections (2b, 2bb).

5. Sensor arrangement according to one of the preceding claims, **characterized in that** the sensor element (1) is sheathed by a film which is composed of electrode material, and **in that** the electrode material is separated for the purpose of forming the first electrode sections (2a, 2aa) and the second electrode sections (2b, 2bb).

6. Method for producing a sensor arrangement for force and/or pressure measurement according to Claim 5, in particular for attachment to a fuel injector for valve needle closing time identification, wherein the sensor element (1) is sheathed by the electrode material which completely encloses the sensor element (1), that the electrode material, for the purpose of forming the electrode sections (2a, 2aa, 2b, 2bb) which are arranged on each of the two end faces (5a, 5b) of the sensor element (1) and form the electrodes, is then separated such that the first electrode sections (2a, 2aa) and second electrode sections (2b, 2bb) are situated opposite one another in a crosswise manner congruently on the two end faces (5a, 5b), and that the first electrode sections (2a, 2aa) and second electrode sections (2b, 2bb) which are formed in this way are respectively connected to one another by means of the casing sections (4a, 4b) of the casing surface (6) of the electrode material.

7. Method for producing a sensor arrangement according to Claim 6, **characterized in that** the sheathing is applied to the sensor material (1) by an immersion process and/or vapour deposition.

8. Method for producing a sensor arrangement according to either of Claims 6 and 7, **characterized in that** the separating joint (3a, 3b) is established by a mechanical separation method or a laser separation method.

## Revendications

1. Arrangement de détection destiné à la mesure de force et/ou de pression, notamment pour le montage sur un injecteur de carburant en vue de détecter l'instant de fermeture d'un pointeau de soupape, comprenant au moins un élément détecteur (1) en un matériau piézoélectrique comportant deux surfaces frontales (5a, 5b) parallèles l'une à l'autre ayant respectivement une électrode associée, une mise en contact de l'élément détecteur (1) avec les électrodes séparées électriquement l'une de l'autre étant réalisée, **caractérisé en ce que** chacune des deux surfaces frontales (5a, 5b) possède deux portions d'électrode (2a, 2b ou 2aa, 2bb) séparées l'une de l'autre et formant les électrodes, les portions d'électrode (2a, 2b ou 2aa, 2bb) étant disposées croisées l'une par rapport à l'autre en référence à la surface frontale (5a, 5b) opposée et étant reliées électriquement entre elles, la liaison croisée des premières portions d'électrode (2a, 2aa) et des deuxièmes portions d'électrode (2b, 2bb) s'effectuant à chaque fois par le biais d'une portion de surface d'enveloppe (4a, 4b).

2. Arrangement de détection selon la revendication 1, **caractérisé en ce que** la séparation est formée par un joint de séparation (3a, 3b).

3. Arrangement de détection selon l'une des revendications précédentes, **caractérisé en ce que** la séparation divise les surfaces frontales (5a, 5b) respectivement en deux portions d'électrode (2a, 2b ou 2aa, 2bb) de même taille.

4. Arrangement de détection selon l'une des revendications précédentes, **caractérisé en ce que** les premières portions d'électrode (2a, 2aa) reliées entre elles de manière croisée sont disposées en coïncidence avec les deuxièmes portions d'électrode (2b, 2bb) respectivement associées.

5. Arrangement de détection selon l'une des revendications précédentes, **caractérisé en ce que** l'élément détecteur (1) est enveloppé avec un film en matériau d'électrode, et **en ce que** le matériau d'électrode est séparé en vue de former les premières portions d'électrode (2a, 2aa) et les deuxièmes portions d'électrode (2b, 2bb).

6. Procédé de fabrication d'un arrangement de détection destiné à la mesure de force et/ou de pression selon la revendication 5, notamment pour un montage sur un injecteur de carburant en vue de détecter l'instant de fermeture d'un pointeau de soupape, l'élément détecteur (1) étant enveloppé avec le matériau d'électrode qui englobe entièrement l'élément détecteur (1), que le matériau d'électrode étant ensuite séparé en vue former les portions d'électrode (2a, 2aa, 2b, 2bb) disposées sur chacune des deux surfaces frontales (5a, 5b) de l'élément détecteur (1) et formant les électrodes de telle sorte que les premières portions d'électrode (2a, 2aa) et les deuxièmes portions d'électrode (2b, 2bb) sont opposées l'une à l'autre de manière croisée en coïncidence sur les deux surfaces frontales (5a, 5b) et que les premières portions d'électrode (2a, 2aa) et les deuxièmes portions d'électrode (2b, 2bb) ainsi formées sont respectivement reliées les unes aux autres par le biais des portions de surface d'enveloppe (4a, 4b) de la surface d'enveloppe (6) du matériau d'électrode.

7. Procédé de fabrication d'un arrangement de détection selon la revendication 6, **caractérisé en ce que** l'enveloppage est appliqué sur le matériau détecteur (1) par une opération d'immersion ou un revêtement en phase vapeur.

8. Procédé de fabrication d'un arrangement de détection selon l'une des revendications 6 ou 7, **caractérisé en ce que** le joint de séparation (3a, 3b) est produit par un procédé de séparation mécanique ou un procédé de séparation au laser.
